# FASCICULE DE BREVET EUROPEEN

(11) **EP 2 916 701 B1**
(45) Date de publication et mention de la délivrance du brevet: **01.02.2017**
(21) Numéro de dépôt: 13801636.5
(22) Date de dépôt: 06.11.2013
(51) Int. Cl.: A47J 36/02

(54) **DISPOSITIF DE CUISSON PRÉSENTANT UNE SURFACE DE CUISSON COMPORTANT UN REVÊTEMENT ANTIADHÉSIF EN CÉRAMIQUE NON OXYDE OU AU MOINS PARTIELLEMENT NON OXYDE, ET ARTICLE CULINAIRE OU APPAREIL ÉLECTROMÉNAGER DE CUISSON COMPORTANT UN TEL DISPOSITIF DE CUISSON**
KOCHVORRICHTUNG MIT EINER KOCHFLÄCHE MIT EINER NICHTHAFTENDEN NICHTOXIDISCHEN ODER ZUMINDEST TEILWEISE NICHTOXIDISCHEN KERAMIKBESCHICHTUNG SOWIE KÜCHENELEMENT ODER ELEKTRISCHE KOCHANWENDUNG MIT SOLCH EINER KOCHVORRICHTUNG
COOKING DEVICE HACING A COOKING SURFACE COMPRISING A NON-OXIDE OR AT LEAST PARTIALLY NON-OXIDE CERAMIC NON-STICK COATING, AND KITCHEN ITEM OR ELECTRICAL COOKING APPLIANCE COMPRISING SUCH A COOKING DEVICE

(30) Priorité: 06.11.2012 FR 1260514
(43) Date de publication de la demande: 16.09.2015
(73) Titulaire: SEB S.A., 69130 Ecully (FR)
(72) Inventeur: ALLEMAND, Simon, 74150 Rumilly (FR); TUFFE, Stéphane, 73160 Cognin (FR)
(74) Mandataire: Novagraaf Technologies
(86) Numéro de dépôt international: PCT/FR2013/052644
(87) Numéro de publication internationale: WO 2014/072635

(56) Documents cités:
- EP-A1- 0 966 910
- US-A1- 2009 191 405
- US-A1- 2009 206 093
- US-A1- 2010 255 340
- US-A1- 2011 293 950
- PAOLO COLOMBO ET AL: "Polymer-Derived Ceramics: 40 Years of Research and Innovation in Advanced Ceramics", JOURNAL OF THE AMERICAN CERAMIC SOCIETY, vol. 93, no. 7, 1 juin 2010 (2010-06-01), pages 1805-1837, XP055086751, ISSN: 0002-7820, DOI: 10.1111/j.1551-2916.2010.03876.x

## Description

La présente invention concerne de manière générale un dispositif de cuisson appartenant à un article culinaire ou à un appareil électroménager de cuisson, présentant au moins une face revêtue d'un revêtement céramique antiadhésif formant une surface de cuisson. La présente invention concerne également un procédé de fabrication d'un tel dispositif de cuisson.

Le domaine visé est en premier lieu celui des articles culinaires, mais la présente invention peut également concerner tout autre type d'articles destinés à la cuisson des aliments tels que les appareils électroménagers destinés à la cuisson des aliments.

L'homme du métier connait l'utilisation de revêtements céramiques oxydes obtenus par voie sol-gel. Il s'agit essentiellement de revêtements obtenus par voie sol-gel à partir de précurseurs de type alcoxysilane.

A l'heure actuelle, il n'est pas possible de réaliser par voie sol-gel des céramiques non oxydes ou au moins partiellement non oxydes (c'est-à-dire des céramiques dont une partie au moins 25% du matériau n'est pas oxyde).

Pour réaliser de telles céramiques (c'est-à-dire des céramiques non oxydes ou au moins partiellement non oxydes), l'homme du métier connait différentes techniques telles que les dépôts physiques en phase vapeur (généralement désigné par l'acronyme anglais PVD pour « *physical vapor deposition* »), par exemple la pulvérisation cathodique magnétron. En particulier, il est possible de déposer par cette technique (pulvérisation cathodique magnétron) des nitrures ou borures de métaux de transition sur des substrats en acier inoxydable. Les revêtements obtenus présentent à la fois des propriétés de dureté et de résistance à l'oxydation importante, mais également un comportement non-adhésif des aliments au cours de la cuisson et une grande facilité de nettoyage en comparaison avec une surface de cuisson en acier inoxydable non revêtue.

Plusieurs documents de l'état de la technique divulguent le dépôt d'un revêtement en céramique non oxyde ou au moins partiellement non oxyde en utilisant la méthode de dépôt PVD. A titre d'exemple, on peut citer le brevet EP0966910 qui décrit un dispositif de cuisson comprenant un support dont la face intérieure de cuisson est revêtue d'une couche de nitrure de zirconium. Cette couche de nitrure de zirconium est obtenue par dépôt PVD.

On peut encore citer le brevet US2010/0255340 qui décrit un article culinaire comportant un fond ou un substrat en cuivre. Une couche de base métallique, par exemple en TiAL ou en AlCr, est déposée sur le substrat en cuivre. Ensuite, une couche céramique, notamment une couche de nitrure ou de carbonitrure, est déposée sur la couche de base métallique par la voie PVD présentée précédemment.

Toutefois, la mise en oeuvre de dépôt sous vide (notamment par pulvérisation cathodique magnétron) présente l'inconvénient d'engendrer des coûts de fabrication élevés.

Pour éviter les contraintes de dépôts sous vide et les couts élevés qu'ils engendrent et obtenir des niveaux de performances équivalents, la demanderesse a mis au point un procédé de réalisation d'un revêtement céramique non oxyde ou au moins partiellement non oxyde sur un support de cuisson par voie polymère précéramique (généralement désignée par l'acronyme anglais PDCs pour « *Polymer Derived Ceramics* »), pour obtenir un dispositif de cuisson.

La voie polymère précéramique est analogue au procédé sol-gel pour la synthèse de matériau non oxyde ou au moins partiellement non oxyde.

Par matériau céramique au moins partiellement non oxyde, on entend, au sens de la présente invention, un matériau céramique comportant une portion non oxyde représentant au moins 25% en pourcentage atomique du revêtement.

A tire d'exemple de matériau complètement oxyde, on peut par exemple citer la silice SiO₂.

A titre d'exemple de matériau au moins partiellement non oxyde et conforme à la présente invention, on peut par exemple citer l'oxycarbure de silicium SiCO.

La présente invention a donc pour objet un dispositif de cuisson présentant un support comprenant une face intérieure et/ou supérieure apte à recevoir des aliments et une face extérieure et/ou inférieure, ladite face intérieure et/ou supérieure étant revêtue d'un revêtement antiadhésif formant une surface de cuisson.

Selon l'invention, le revêtement antiadhésif comprend au moins un film mince continu de céramique non oxyde dérivée de polymère ou de céramique au moins partiellement non oxyde dérivée de polymère, le film mince formant la surface de cuisson et ledit film mince présente une épaisseur comprise entre 0,5 et 50 µm.

Au sens de la présente invention, le film mince est en céramique dérivée de polymère, qu'il s'agisse d'une céramique non oxyde ou d'une céramique au moins partiellement non oxyde.

Le dispositif de cuisson selon l'invention muni d'un tel revêtement présente les avantages combinés suivants :
- non adhésion des aliments au cours de la cuisson,
- excellente facilité de nettoyage et pérennité de cette facilité de nettoyage,
- résistance à la rayure,
- résistance au tachage,
- stabilité de la couleur et de l'aspect.

De manière avantageuse, la céramique non oxyde ou au moins non partiellement oxyde du revêtement antiadhésif selon l'invention est obtenue à partir d'au moins un polymère précéramique répondant à la formule générale (1) : 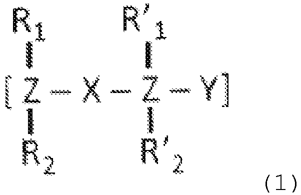 avec :
- X désignant un élément choisi parmi O, B, N ou C,
- Y désignant un élément choisi parmi B, N, C, C=C, et =C=N,
- Z désignant un élément métallique choisi parmi les métaux de transition, le silicium et l'aluminium,
- R₁, R'₁, R₂, R'₂ désigne H ou une chaîne hydrocarbonée de type alkyle, phényle, acyle ou aralkyle.

Un tel polymère précéramique subit, après sa mise en forme sur le substrat (en l'occurrence par dépôt suivant différentes techniques telles que la centrifugation ou « *spin-coating* », la pulvérisation ou le trempage), une étape de traitement thermique pour céramiser le prépolymère, c'est-à-dire pour transformer le prépolymère précéramique en un revêtement céramique.

La céramisation du prépolymère de formule (1) permet d'élaborer des revêtements non oxyde ou au moins partiellement non oxyde de pureté très élevée et présentant une distribution homogène des éléments même à l'échelle atomique. A partir d'un tel prépolymère, il est possible d'obtenir des revêtements avec une grande diversité de composition chimique : il est ainsi possible de réaliser des revêtements en nitrure, borure ou carbure de métaux de transition, de silicium, d'aluminium. Des combinaisons de ces différents systèmes sont également réalisables (ex : SiBN, SiBCN, SiCO, SiBO, SiBOC, ...).

Le film mince continu de céramique non oxyde ou au moins partiellement non oxyde présente une épaisseur comprise entre 0,5 et 50 µm, et de préférence entre 5 et 20 µm.

La voie prépolymère céramique utilisée dans le cadre de la présente invention permet de déposer des épaisseurs de revêtement importantes et avec des temps de cycle beaucoup plus courts que par la voie PVD, par laquelle on peut déposer, avec des temps de cycle raisonnables et industriellement réalistes, des épaisseurs de revêtement d'au plus 5 µm.

A titre de support utilisable pour réaliser le dispositif de cuisson selon l'invention, il peut s'agir en particulier d'un support présentant la forme finale d'un réceptacle de cuisson d'un article culinaire, avec une face intérieure et/ou supérieure apte à recevoir des aliments et une face extérieure et/ou inférieure destinée à être disposée du côté d'une source de chaleur. Il peut s'agir aussi d'un support présentant la forme finale d'un dispositif de cuisson d'un appareil électroménager de cuisson comportant des moyens de chauffe, avec une face intérieure et/ou supérieure apte à recevoir des aliments et une face extérieure et/ou inférieure portée par l'appareil, le dispositif de cuisson pouvant être amovible ou non de l'appareil.

Le support utilisable dans le cadre de la présente invention pourra avantageusement être réalisé dans un matériau choisi parmi les métaux, le verre, les céramiques et les vitrocéramiques.

A titre de supports métalliques utilisables dans le procédé selon l'invention, on peut avantageusement citer les supports en aluminium ou en alliage d'aluminium, anodisé ou non, ou en aluminium poli, brossé ou microbillé, ou en acier inoxydable poli, brossé ou microbillé, ou en fonte d'acier ou d'aluminium, ou en cuivre martelé ou poli. On peut également citer les supports composites multicouches, par exemple les supports bicouches aluminium (ou alliage d'aluminium) /acier inoxydable et les supports tri-couches acier inoxydable /aluminium (ou alliage d'aluminium) /acier inoxydable.

De manière avantageuse, le revêtement antiadhésif du dispositif de cuisson selon l'invention peut en outre comporter au moins une sous-couche de céramique non oxyde ou au moins partiellement non oxyde sous le film mince de céramique.

De manière avantageuse, l'un au moins de la sous-couche et dudit film mince peut comprendre au moins une charge et/ou au moins un pigment.

A titre de charges utilisables dans le cadre de la présente invention (soit dans la sous-couche, soit dans le film), on peut notamment citer les particules d'Al₂O₃, de SiC, de Si₃N₄, de B₄C, de TiC, TiB₂, CrB₂, ZrB₂ et leurs mélanges.

De manière avantageuse, la charge est présente à raison d'au plus 50% en masse par rapport à la masse totale de la sous-couche ou du film mince.

La présence de charges dans la sous-couche et/ou dans le film mince amène des avantages multiples : elle permet d'augmenter la résistance à la rayure, d'améliorer les propriétés de facilité de nettoyage et de non-adhésion, de mieux maîtriser la porosité du revêtement, et aussi de limiter la fissuration du revêtement lors de son élaboration.

La possibilité d'incorporer des pigments dans la sous-couche et/ou dans le film mince permet quant à elle d'en modifier la coloration.

La présente invention a également pour objet un article culinaire comportant un dispositif de cuisson selon la revendication 1.

Un tel article culinaire peut être notamment une poêle, une casserole, un faitout, un wok..., le support formant alors une cuve. Si désiré, une ou plusieurs poignées peuvent être fixées au dispositif de cuisson pour former l'article culinaire.

Enfin, la présente invention a encore pour objet un appareil électroménager de cuisson comportant un dispositif de cuisson selon la revendication 1.

Le dispositif de cuisson peut être amovible ou non de l'appareil. Si désiré, des moyens de chauffe peuvent être solidaires du support. Ainsi, la face extérieure et/ou inférieure n'est pas nécessairement destinée à être disposée du côté d'une source de chaleur. Un tel appareil électroménager peut être notamment un cuiseur électrique comportant une cuve, un appareil à raclette comportant des coupelles, une machine à pain, un appareil comportant une plaque de cuisson, tel qu'une plancha, un gaufrier....

La présente invention a également pour objet un procédé de fabrication d'un dispositif de cuisson, caractérisé en ce qu'il comprend les étapes suivantes :
a) une étape de fourniture et/ou de réalisation d'un support présentant au moins deux faces opposées ;
b) une étape de préparation d'un polymère précéramique à partir d'un précurseur moléculaire dudit polymère comprenant la mise en suspension dudit précurseur moléculaire dans un fluide, ce fluide pouvant être un solvant organique ou de l'eau, puis sa polymérisation pour obtenir une composition de polymère précéramique ;
c) une étape d'application sur l'une au moins des faces du support d'au moins une couche de ladite composition de polymère précéramique ;
d) optionnellement une étape de séchage, et
e) une étape de traitement thermique pour céramiser ledit polymère précéramique et former ainsi un film mince de céramique non oxyde dérivée de polymère ou de céramique au moins partiellement non oxyde dérivée de polymère.

Dans le cadre du procédé selon l'invention, le film mince est fabriqué sur l'une au moins des faces du support par voie polymère précéramique. Ce processus est analogue au procédé sol-gel pour la synthèse de matériau non oxyde (ou au moins partiellement non oxyde), et constitue une voie alternative au dépôt sous vide tel que celui réalisé par pulvérisation cathodique magnétron pour élaborer des revêtements de type borure, diborure ou nitrure de métaux de transition.

Contrairement à la voie par pulvérisation cathodique magnétron, la voie polymère précéramique, qui ne nécessite pas de réaliser le dépôt sous vide secondaire et donc dans des conditions d'élaboration beaucoup plus sévère, permet donc un coût de fabrication non prohibitif du revêtement, qui est nécessaire pour la viabilité économique du projet.

Le support est tel que défini précédemment. Il peut s'agir en particulier d'un support présentant la forme finale d'un dispositif de cuisson selon la revendication 1 d'un article culinaire, avec une face intérieure et/ou supérieure apte à recevoir des aliments et une face extérieure et/ou inférieure destinée à être disposée du côté d'une source de chaleur, ou d'un support présentant la forme finale d'un dispositif de cuisson selon la revendication 1 d'un appareil électroménager de cuisson comportant des moyens de chauffe, avec une face intérieure et/ou supérieure apte à recevoir des aliments et une face extérieure et/ou inférieure portée par l'appareil, le dispositif de cuisson pouvant être amovible ou non de l'appareil. Le dispositif de cuisson forme par exemple une plaque, une coupelle ou une cuve.

Le polymère précéramique est également tel que défini précédemment et répond à la formule générale (1) définie plus haut. Il est obtenu lors de l'étape b) du procédé de l'invention à partir d'un précurseur moléculaire du polymère, qui est choisi en fonction de la composition chimique de la céramique finale souhaitée.

Ainsi, si l'on souhaite réaliser un film mince en nitrure de niobium, on peut utiliser à titre de précurseurs moléculaires des précurseurs de type Nb(NR₂)₅ ou (NR₂)₃Nb=NR sont utilisés. Ces précurseurs peuvent être synthétisés à partir de NbCl₅ + LiNMe₂ (le terme Me désignant un groupement méthyle). On peut également envisager la réaction directe de NbCl₅ avec une amine (NH₃ ou NH₂R).

Si l'on souhaite réaliser un film mince en borure de chrome, on peut utiliser à titre de précurseurs moléculaires des précurseurs de type Cr(BH₄)₅. Ils peuvent être synthétisés à partir de CrCl₃ + soit NaBH₄, soit KBF4, soit NH₃BH₃, tous précurseurs commerciaux. Ces précurseurs du borure de chrome sont transposables au système TiB₂ ou plus généralement XB₂, X étant un métal de transition.

Si l'on souhaite réaliser un film mince en un composé du silicium, de nombreux précurseurs peuvent être utilisés en fonction de la nature du revêtement visé (nitrure de silicium, carbure de silicium, boronitrure de silicium, carbonitrure de silicium, ...). De nombreuses combinaisons sont possible :
▪ pour fabriquer un film de SiC, on peut utiliser à titre de précurseur moléculaire un polycarbosilane,
▪ pour fabriquer un film de SiCO, on peut utiliser notamment à titre de précurseur moléculaire un polycarbosiloxane,
▪ pour fabriquer un film de SiBO, on peut utiliser notamment à titre de précurseur moléculaire un polyborosiloxane.

Les précurseurs moléculaires sont mis en suspension dudit précurseur moléculaire dans un fluide, par exemple un solvant organique ou de l'eau, afin de former une suspension stable. Des additifs sont ajoutés afin d'obtenir une viscosité adapté au procédé de mis en forme utilisé.

Cette suspension est ensuite appliquée sur l'une des faces du support (étape c) du procédé selon l'invention, pour former une couche de polymère précéramique recouvrant la face intérieure du support. Cette application peut être réalisée par pulvérisation (« *spray-coating* »), trempage (« *dip-coating* ») ou dépôt à la tournette (« *spin-coating* »).

L'avantage de la voie polymère précéramique réside notamment dans le fait que le produit de départ est une suspension de précurseur(s) moléculaire(s) dont les propriétés chimiques et rhéologiques sont telles qu'elles sont compatibles avec un grand nombre de procédés industriels de mise en forme, tels que ceux précités.

Après la mise en forme, la couche de polymère précéramique recouvrant la face intérieure du support est soumise à un traitement thermique e) approprié (éventuellement précédé d'une étape de séchage), qui achève le processus de céramisation du revêtement et permet l'obtention d'un film mince de céramique non oxyde dérivée de polymère.

L'intérêt d'une céramisation réalisée à partir d'un polymère précéramique réside ainsi dans leur relativement plus faible température de synthèse par rapport à un procédé classique de frittage de poudre céramique.

L'étape e) de traitement thermique peut être réalisée de différentes manières, et notamment par pyrolyse dans un four résistif à une température inférieure à 1000°C ou dans un four à recuit rapide (ou four RTA pour « *Rapid Thermal Annealing* »)

Toutefois, les températures atteintes restent élevées lors de la pyrolyse permettant la conversion du polymère précéramique en céramique (entre 800°C et 1200°C), et les risques d'endommagement et de déformation du substrat métallique (en particulier dans le cas d'un article culinaire tel qu'une poêle) sont donc importants.

Par conséquent, l'étape de traitement thermique sera de préférence réalisés dans un four à recuit rapide (ou four RTA), à une température maximale de 1350°C pendant une durée inférieure à 4 heures. Dans ce cas, seul la couche de polymère précéramique reçoit la chaleur par absorption de l'irradiation, et le substrat métallique est alors uniquement chauffé par conduction, limitant ainsi fortement la température atteinte par le substrat.

Le traitement thermique peut être réalisé sous gaz inerte ou réactif en fonction de la nature de la céramique visée.

Lors du traitement thermique, il peut apparaître un retrait volumique provenant du départ de produits dus à l'avancement de la réticulation des espèces précéramiques. L'incorporation de charges dispersées dans la matrice céramique permet de régler ce problème, ces charges pouvant de plus jouer un rôle de renfort du revêtement, améliorant ainsi la résistance à la rayure de la surface.

Le procédé selon l'invention conduit à un film en céramique de densité plus faible que celle que l'on obtiendrait par dépôt PVD par exemple. Par conséquent, un tel procédé permet d'incorporer des huiles alimentaires au niveau des porosités du revêtement céramique formé (film avec ou sans sous-couche) et d'améliorer ainsi les propriétés de non adhésion et de facilité de nettoyage.

Sauf indication contraire, tous les pourcentages de composants de la présente demande sont exprimés en pourcentages massiques. L'invention est illustrée plus en détail dans les exemples suivants.

### EXEMPLES

### Produits

### Précurseurs moléculaires

- l'allyhydridopolycarbosilane, commercialisé sous la dénomination commerciale AHPCS par la société Starfire Systems (pour l'obtention d'un film mince de SiC),
- le produit commercial polyramic® SPR-036 de la société Starfire Systems (pour l'obtention d'un film mince de SiₓC_{y}O_{z}).

**Support** : substrat en acier inoxydable, lisse ou sablé.

On réalise, conformément au procédé de l'invention, le dépôt d'un film mince de SiC sur le substrat en acier inoxydable, en procédant comme suit :
1. Le précurseur moléculaire est mis en solution dans du THF (tétrahydrofurane). D'autres solvants, tels que le toluène peuvent également être utilisés. Une concentration de 20% de précurseur dans le solvant permet d'obtenir un revêtement sans craquelures. Au-delà de cette valeur, on observe sur le revêtement final, après céramisation, des porosités et des craquelures du revêtement très importantes. En-deçà de cette valeur, la topologie du revêtement est trop proche de celle du substrat et il est alors difficile d'obtenir les épaisseurs visées
2. La mise en forme est réalisée par trempage (« *dip coating* »), le temps de trempage étant fixé à 2 minutes. Pour des temps de trempage plus important, on obtiendrait une épaisseur de film plus importante, qui serait susceptible d'entraîner la formation de porosités et de craquelures du revêtement lors de la montée en température. Plusieurs étapes de trempage sont nécessaires pour obtenir un revêtement d'épaisseur suffisante (de l'ordre de 10µm) et limiter la fissuration.
3. Le traitement thermique permettant la conversion du polymère précéramique en céramique est réalisé dans un four en deux étapes, sous air ou sous argon, selon les cas :
   ▪ Pour l'obtention d'un film de SiC, le procédé est le suivant :
      *Dip coating* → Pyrolyse sous air à 1000° pendant 2heures → *Dip coating* → Pyrolyse sous Argon à 800°C pendant 2heures.
      La 1^{ère} pyrolyse sous air permet l'obtention d'une sous-couche « oxydée » et une meilleure adhérence du revêtement final
   ▪ Pour l'obtention d'un film de Si₂C_{y}O₂, le procédé est le suivant :
      *Dip coating* → Pyrolyse sous Argon à 1000°C pendant 2 heures→ *Dip coating* → Pyrolyse sous Argon à 800°C pendant 2 heures.

D'autres procédés de mise en forme (« *spray coating* » ou « *spin coating* ») ou de traitement thermique (four RTA) sont également envisageables pour l'obtention de ces revêtements.

## Revendications

1. Dispositif de cuisson présentant un support comprenant une face intérieure et/ou supérieure apte à recevoir des aliments et une face extérieure et/ou inférieure, ladite face intérieure et/ou supérieure étant revêtue d'un revêtement antiadhésif formant une surface de cuisson,
**caractérisé en ce que** ledit revêtement antiadhésif comprend au moins un film mince continu de céramique non oxyde dérivée de polymère ou de céramique au moins partiellement non oxyde dérivée de polymère, ledit film mince formant la surface de cuisson et présentant une épaisseur comprise entre 0,5 et 50 µm.

2. Dispositif de cuisson selon la revendication 1, **caractérisé en ce que** la céramique non oxyde ou au moins partiellement non oxyde est obtenue à partir d'au moins un polymère précéramique répondant à la formule générale (1) : 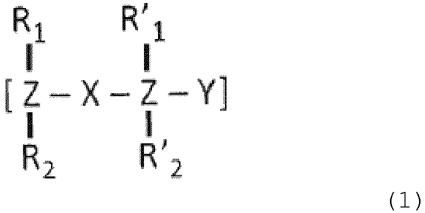 avec :
- X désignant un élément choisi parmi O, B, N ou C,
- Y désignant un élément choisi parmi B, N, C, C=C, et =C=N,
- Z désignant un élément métallique choisi parmi les métaux de transition, le silicium et l'aluminium,
- R₁, R'₁, R₂, R'₂ désigne H ou une chaîne hydrocarbonée de type alkyle, phényle, acyle ou aralkyle.

3. Dispositif de cuisson selon l'une quelconque des revendications 1 ou 2, **caractérisé en ce que** le support est en un matériau choisi parmi les métaux, le verre, les céramiques et les vitrocéramiques.

4. Dispositif de cuisson selon la revendication 3, **caractérisé en ce que** le support est métallique et comprend une structure:
- monocouche en aluminium anodisé ou non, ou en aluminium poli, brossé ou microbillé, sablé, traité chimiquement, ou en fonte d'aluminium, en acier notamment inoxydable, pouvant être poli, brossé ou microbillé, ou en fonte, ou en cuivre martelé ou poli ; ou
- multicouches comprenant de l'extérieur vers l'intérieur les couches suivantes acier inoxydable ferritique / aluminium/acier inoxydable austénitique ou encore acier inoxydable / aluminium / cuivre / aluminium / acier inoxydable austénitique, ou encore une calotte d'aluminium de fonderie, d'aluminium ou d'alliages d'aluminium doublée d'un fond extérieur en acier inoxydable.

5. Dispositif de cuisson selon l'une quelconque des revendications 1 à 4, **caractérisé en ce que** ledit revêtement antiadhésif comporte au moins une sous-couche de céramique non oxyde ou au moins partiellement non oxyde, ladite sous-couche étant disposée sous ledit film mince.

6. Dispositif de cuisson selon l'une quelconque des revendications 1 à 5, **caractérisé en ce que** la sous-couche et/ou ledit film mince comprend au moins une charge et/ou au moins un pigment.

7. Dispositif de cuisson selon la revendication 6, **caractérisé en ce que** la charge est choisie dans le groupe constitué d'Al₂O₃, SiC, Si₃N₄, B₄C, TiC, TiB₂, CrB₂, ZrB₂ et leurs mélanges.

8. Dispositif de cuisson selon l'une des revendications 6 ou 7, **caractérisé en ce que** la charge est présente à raison d'au plus 50% en masse par rapport à la masse totale de la sous-couche ou dudit film mince.

9. Article culinaire comportant un dispositif de cuisson présentant un support comprenant une face intérieure et/ou supérieure apte à recevoir des aliments et une face extérieure et/ou inférieure destinée à être disposée du côté d'une source de chaleur, ladite face intérieure et/ou supérieure étant revêtue d'un revêtement antiadhésif formant une surface de cuisson, **caractérisé en ce que** le dispositif de cuisson est conforme à l'une des revendications 1 à 8.

10. Appareil électroménager de cuisson comportant un dispositif de cuisson présentant un support comprenant une face intérieure et/ou supérieure apte à recevoir des aliments et une face extérieure et/ou inférieure portée par ledit appareil, ladite face intérieure et/ou supérieure étant revêtue d'un revêtement antiadhésif formant une surface de cuisson, **caractérisé en ce que** le dispositif de cuisson est conforme à l'une des revendications 1 à 8.

11. Procédé de fabrication d'un dispositif de cuisson, **caractérisé en ce qu'**il comprend les étapes suivantes :
a) une étape de fourniture et/ou de réalisation d'un support présentant au moins deux faces opposées ;
b) une étape de préparation d'un polymère précéramique à partir d'un précurseur moléculaire dudit polymère comprenant la mise en suspension dudit précurseur moléculaire dans un fluide, ce fluide pouvant être un solvant organique ou de l'eau, puis sa polymérisation pour obtenir une composition de polymère précéramique ;
c) une étape d'application sur l'une au moins des faces du support d'au moins une couche de ladite composition de polymère précéramique ;
d) optionnellement une étape de séchage, et
e) une étape de traitement thermique pour céramiser ledit polymère précéramique et former ainsi un film mince de céramique non oxyde dérivée de polymère ou de céramique au moins partiellement non oxyde dérivée de polymère.

12. Procédé selon la revendication 11, **caractérisé en ce que** le polymère précéramique répond à la formule générale (1) 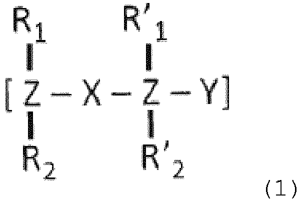 avec :
- X désignant un élément choisi parmi O, B, N ou C,
- Y désignant un élément choisi parmi B, N, C, C=C, et =C=N,
- Z désignant un élément métallique choisi parmi les métaux de transition, le silicium et l'aluminium,
- R₁, R'₁, R₂, R'₂ désigne H ou une chaîne hydrocarbonée de type alkyle, phényle, acyle ou aralkyle.

13. Procédé selon l'une des revendications 11 ou 12, **caractérisé en ce que** l'application de ladite composition de polymère précéramique est réalisée par pulvérisation, trempage ou dépôt à la tournette.

14. Procédé selon l'une quelconque des revendications 11 à 13, **caractérisé en ce que** l'étape de traitement thermique est réalisé dans un four à recuit rapide, à une température maximale de 1350°C pendant une durée inférieure à 4 heures.

15. Procédé selon l'une quelconque des revendications 11 à 14, **caractérisé en ce que** le support présente la forme finale du dispositif de cuisson, comportant un fond avec une face intérieure et/ou supérieure apte à recevoir des aliments et une face extérieure et/ou inférieure destinée à être disposée du côté d'une source de chaleur.

## Patentansprüche

1. Kochvorrichtung mit einem Träger, umfassend eine Innen- und/oder Oberseite, die geeignet ist, Lebensmittel aufzunehmen, und eine Außen- und/oder Unterseite, wobei die Innen- und/oder Oberseite mit einer nichthaftenden Beschichtung beschichtet ist, die eine Kochfläche bildet,
**dadurch gekennzeichnet, dass** die nichthaftende Beschichtung mindestens eine kontinuierliche dünne Schicht nichtoxidischer, von Polymer abgeleiteter Keramik oder zumindest teilweise nichtoxidischer, von Polymer abgeleiteter Keramik umfasst, wobei die dünne Schicht die Kochfläche bildet und eine Dicke zwischen 0,5 und 50 µm aufweist.

2. Kochvorrichtung nach Anspruch 1, **dadurch gekennzeichnet, dass** die nichtoxidische Keramik oder zumindest teilweise nichtoxidische Keramik aus mindestens einem vorkeramischen Polymer gewonnen wird, das der allgemeinen Formel (1) entspricht: 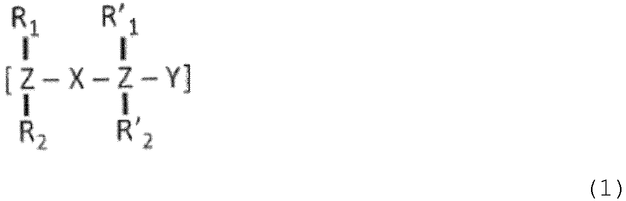 wobei:
- X ein Element bezeichnet, das aus O, B, N oder C ausgewählt ist,
- Y ein Element bezeichnet, das aus B, N, C, C=C und =C=N ausgewählt ist,
- Z ein metallisches Element bezeichnet, das aus den Übergangsmetallen, Silizium und Aluminium, ausgewählt ist,
- R₁, R'₁, R₂, R'₂ H oder eine Kohlenstoffwasserstoffkette vom Typ Alkyl, Phenyl, Acyl oder Aralkyl bezeichnet.

3. Kochvorrichtung nach einem der Ansprüche 1 oder 2, **dadurch gekennzeichnet, dass** der Träger aus einem Material ist, das aus Metallen, Glas, Keramiken und Glaskeramiken ausgewählt ist.

4. Kochvorrichtung nach Anspruch 3, **dadurch gekennzeichnet, dass** der Träger metallisch ist und eine Struktur umfasst:
- einzelschichtig aus anodisiertem oder nicht anodisiertem Aluminium oder aus poliertem, gebürstetem oder mikrosandgestrahltem, sandgestrahltem, chemisch behandeltem Aluminium oder aus Aluminiumguss, aus Stahl, insbesondere rostfreiem, der poliert, gebürstet oder mikrosandgestrahlt oder aus Guss sein kann, oder aus gehämmertem oder poliertem Kupfer; oder
- mehrschichtig, umfassend die folgenden Schichten von außen nach innen: ferritisch rostfreier Stahl / Aluminium / austenitisch rostfreier Stahl oder auch rostfreier Stahl / Aluminium / Kupfer / Aluminium / austenitisch rostfreier Stahl oder auch eine Kalotte aus Aluminiumguss, aus Aluminium oder Aluminiumlegierungen, gedoppelt durch einen Außenboden aus rostfreiem Stahl.

5. Kochvorrichtung nach einem der Ansprüche 1 bis 4, **dadurch gekennzeichnet, dass** die nichthaftende Beschichtung mindestens eine nichtoxidische oder zumindest teilweise nichtoxidische keramische Unterschicht umfasst, wobei die Unterschicht unter der dünnen Schicht angeordnet ist.

6. Kochvorrichtung nach einem der Ansprüche 1 bis 5, **dadurch gekennzeichnet, dass** die Unterschicht und/oder die dünne Schicht mindestens eine Ladung und/oder mindestens ein Pigment umfasst.

7. Kochvorrichtung nach Anspruch 6, **dadurch gekennzeichnet, dass** die Ladung aus der Gruppe bestehend aus Al₂O₃, SiC, Si₃N₄, B₄C, TiC, TiB₂, CrB₂, ZrB₂ und ihren Mischungen ausgewählt ist.

8. Kochvorrichtung nach einem der Ansprüche 6 oder 7, **dadurch gekennzeichnet, dass** die Ladung vorhanden ist aufgrund der höchstens 50 % Masse der Unterschicht oder der dünnen Schicht im Verhältnis zur Gesamtmasse.

9. Küchenelement, umfassend eine Kochvorrichtung mit einem Träger, umfassend eine Innen- und/oder Oberseite, die geeignet ist, Lebensmittel aufzunehmen, und eine Außen- und/oder Unterseite, die dazu bestimmt ist, neben einer Wärmequelle angeordnet zu werden, wobei die Innen- und/oder Oberseite mit einer nichthaftenden Beschichtung beschichtet ist, die eine Kochfläche bildet, **dadurch gekennzeichnet dass** die Kochvorrichtung einem der Ansprüche 1 bis 8 entspricht.

10. Elektrische Kochanwendung, umfassend eine Kochvorrichtung mit einem Träger, umfassend eine Innen- und/oder Oberseite, die geeignet ist, Lebensmittel aufzunehmen, und eine Außen- und/oder Unterseite, die dazu bestimmt ist, neben einer Wärmequelle angeordnet zu werden, wobei die Innen- und/oder Oberseite mit einer nichthaftenden Beschichtung beschichtet ist, die eine Kochfläche bildet, **dadurch gekennzeichnet, dass** die Kochvorrichtung einem der Ansprüche 1 bis 8 entspricht.

11. Herstellungsverfahren für eine Kochvorrichtung, **dadurch gekennzeichnet, dass** es die folgenden Schritte umfasst:
a) einen Schritt der Bereitstellung und/oder der Realisierung eines Trägers mit mindestens zwei entgegengesetzten Seiten;
b) einen Schritt der Vorbereitung eines vorkeramischen Polymers ausgehend von einem molekularen Vorläufer des Polymers, umfassend die Suspendierung des molekularen Vorläufers in einem Fluid, wobei dieses Fluid ein organisches Lösungsmittel oder Wasser sein kann, dann seine Polymerisierung, um eine Zusammensetzung eines vorkeramischen Polymers zu erhalten;
c) einen Schritt des Auftragens einer Schicht der Zusammensetzung des vorkeramischen Polymers auf mindestens einer der Seiten des Trägers;
d) optional einen Schritt der Trocknung und
e) einen Schritt der thermischen Behandlung zum Keramisieren des vorkeramischen Polymers und so zum Bilden einer dünnen Schicht nichtoxidischer, von Polymer abgeleiteter Keramik oder zumindest teilweise nicht oxidischer, von Polymer abgeleiteter Keramik.

12. Verfahren nach Anspruch 11, **dadurch gekennzeichnet, dass** das vorkeramische Polymer der allgemeinen Formel (1) entspricht: 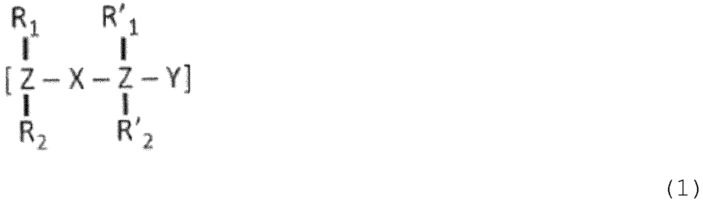 wobei:
- X ein Element bezeichnet, das aus O, B, N oder C ausgewählt ist,
- Y ein Element bezeichnet, das aus B, N, C, C=C und =C=N ausgewählt ist,
- Z ein metallisches Element bezeichnet, das aus den Übergangsmetallen, Silizium und Aluminium, ausgewählt ist,
- R₁, R'₁, R₂, R'₂ H oder eine Kohlenstoffwasserstoffkette vom Typ Alkyl, Phenyl, Acyl oder Aralkyl bezeichnet.

13. Verfahren nach einem der Ansprüche 11 oder 12, **dadurch gekennzeichnet, dass** das Auftragen der Zusammensetzung des vorkeramischen Polymers durch Aufsprühen, Tauchen oder Aufschleudern durchgeführt wird.

14. Verfahren nach einem der Ansprüche 11 bis 13, **dadurch gekennzeichnet, dass** der Schritt der thermischen Behandlung in einem Schnelltemperofen bei einer Höchsttemperatur von 1350 °C über eine Dauer von weniger als 4 Stunden durchgeführt wird.

15. Verfahren nach einem der Ansprüche 11 bis 14, **dadurch gekennzeichnet, dass** der Träger die endgültige Form der Kochvorrichtung darstellt, umfassend einen Boden mit einer Innen- und/oder Oberseite, die geeignet ist, Lebensmittel aufzunehmen, und einer Außen- und/oder Unterseite, die dazu bestimmt ist, neben einer Wärmequelle angeordnet zu werden.

## Claims

1. Cooking device exhibiting a support comprising an internal and/or upper face capable of receiving foodstuffs and an external and/or lower face, the said internal and/or upper face being coated with a non-stick coating forming a cooking surface,
**characterized in that** the said non-stick coating comprises at least a thin continuous film of polymer-derived non-oxide ceramic or of at least partially polymer-derived non-oxide ceramic, the said thin film forming the cooking surface and exhibiting a thickness of between 0.5 and 50 µm.

2. Cooking device according to Claim 1, **characterized in that** the non-oxide or at least partially non-oxide ceramic is obtained from at least one preceramic polymer corresponding to the general formula (1): 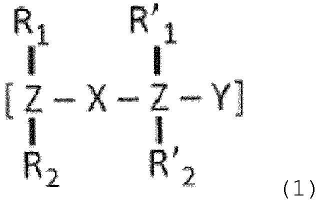 with:
- X denoting an element chosen from O, B, N or C,
- Y denoting an element chosen from B, N, C, C=C and =C=N,
- Z denoting a metal element chosen from transition metals, silicon and aluminium,
- R_{1'} R'₁, R₂ and R'₂ denoting H or a hydrocarbon chain of alkyl, phenyl, acyl or aralkyl type.

3. Cooking device according to either one of Claims 1 and 2, **characterized in that** the support is made of a material chosen from metals, glass, ceramics and glass-ceramics.

4. Cooking device according to Claim 3, **characterized in that** the support is made of metal and comprises a:
- monolayer structure made of anodized or non-anodized aluminium, or made of polished, brushed or microbead-treated, sand blasted, chemically treated aluminium, or made of cast aluminium, made of steel, in particular stainless steel, which can be polished, brushed or microbead-treated, or made of cast iron, or made of hammered or polished copper; or
- multilayer structure comprising, from the outside towards the inside, the following layers: ferritic stainless steel/aluminium/austenitic stainless steel, or also stainless steel/aluminium/copper/aluminium/austenitic stainless steel, or also a shell of cast aluminium, of aluminium or of aluminium alloys which is lined with an external bottom made of stainless steel.

5. Cooking device according to any one of Claims 1 to 4, **characterized in that** the said non-stick coating comprises at least one underlayer of non-oxide or at least partially non-oxide ceramic, the said underlayer being positioned under the said thin film.

6. Cooking device according to any one of Claims 1 to 5, **characterized in that** the underlayer and/or the said thin film comprises at least one filler and/or at least one pigment.

7. Cooking device according to Claim 6, **characterized in that** the filler is chosen from the group consisting of Al₂O₃, SiC, Si₃N₄, B₄C, TiC, TiB₂, CrB₂, ZrB₂ and their mixtures.

8. Cooking device according to either of Claims 6 and 7, **characterized in that** the filler is present in a proportion of more than 50% by weight, with respect to the total weight of the underlayer or of the said thin film.

9. Cooking utensil comprising a cooking device exhibiting a support comprising an internal and/or upper face capable of receiving foodstuffs and an external and/or lower face intended to be positioned on the side of a heat source, the said internal and/or upper face being coated with a non-stick coating forming a cooking surface, **characterized in that** the cooking device is in accordance with one of Claims 1 to 8.

10. Domestic electrical cooking appliance comprising a cooking device exhibiting a support comprising an internal and/or upper face capable of receiving foodstuffs and an external and/or lower face carried by the said appliance, the said internal and/or upper face being coated with a non-stick coating forming a cooking surface, **characterized in that** the cooking device is in accordance with one of Claims 1 to 8.

11. Process for the manufacture of a cooking device, **characterized in that** it comprises the following stages:
a) a stage of providing and/or producing a support exhibiting at least two opposite faces;
b) a stage of preparation of a preceramic polymer from a molecular precursor of the said polymer comprising the suspending of the said molecular precursor in a fluid, it being possible for this fluid to be an organic solvent or water, followed by its polymerization in order to obtain a preceramic polymer composition;
c) a stage of application to at least one of the faces of the support of at least one layer of the said preceramic polymer composition;
d) optionally a drying stage, and
e) a heat treatment stage in order to ceramize the said preceramic polymer and to thus form a thin film of polymer-derived non-oxide ceramic or of at least partially polymer-derived non-oxide ceramic.

12. Process according to Claim 11, **characterized in that** the preceramic polymer corresponds to the general formula (1) 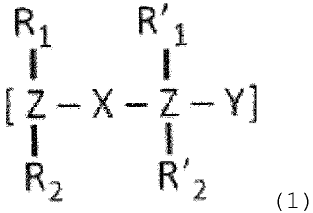 with:
- X denoting an element chosen from O, B, N or C,
- Y denoting an element chosen from B, N, C, C=C and =C=N,
- Z denoting a metal element chosen from transition metals, silicon and aluminium,
- R_{1'} R'₁, R₂ and R'₂ denoting H or a hydrocarbon chain of alkyl, phenyl, acyl or aralkyl type.

13. Process according to either of Claims 11 and 12, **characterized in that** the application of the said preceramic polymer composition is carried out by spraying, dipping or spin coating.

14. Process according to any one of Claims 11 to 13, **characterized in that** the heat treatment stage is carried out in a rapid annealing furnace at a maximum temperature of 1350°C for a period of time of less than 4 hours.

15. Process according to any one of Claims 11 to 14, **characterized in that** the support exhibits the final shape of the cooking device, comprising a bottom with an internal and/or upper face capable of receiving foodstuffs and an external and/or lower face intended to be positioned on the side of a heat source.
